# EUROPEAN PATENT APPLICATION

(11) **EP 4 394 853 A1**
(43) Date of publication of application: **03.07.2024**
(21) Application number: 22861597.7
(22) Date of filing: 10.08.2022
(51) Int. Cl.: H01L 21/67, H01L 21/677, H01L 25/075, H05K 13/04, H01L 21/52

(54) **MICRO-LED CHIP REWORK DEVICE AND REWORK METHOD USING TRANSFER METHOD**

(30) Priority: 25.08.2021 KR 20210112554
(71) Applicant: Laserssel Co., Ltd, Asan-si, Chungcheongnam-do 31499 (KR)
(72) Inventor: CHOI, Jae Joon, Gwangju-si Gyeonggi-do 12771 (KR); KIM, Byung Roc, Incheon 21974 (KR)
(74) Representative: López Camba, Emilia
(86) International application number: PCT/KR2022/011912
(87) International publication number: WO 2023/027387

(57) **Abstract**

An ultra-small LED chip rework apparatus using a transfer technique according to the present invention is characterized by including a detach press head in a stick-shaped configuration with a second adhesive layer stronger than a first adhesive layer at the lower end and capable of transferring a defective ultra-small LED chip attached to the first adhesive layer to the second adhesive layer by applying pressure to the upper surface of the defective ultra-small LED chip, and a driving unit that moves the detach press head on the substrate in the X, Y, and Z-axis directions.

## Description

### TECHNICAL FIELD

The present invention relates to an apparatus and method for reworking ultra-small LED chips. More specifically, it provides an ultra-small LED chip rework apparatus and rework method that can quickly and accurately remove defective mini or micro LED chips from the substrate using a transfer technique in cases where misalignment or defects occur due to slight vibrations or shocks during chip bonding process. Furthermore, it allows for the rapid and accurate attachment of reworked mini or micro LED chips to the substrate using the transfer technique at the position where the defective mini or micro LED chips have been removed, thereby significantly improving process efficiency, precision, and reducing tact time.

### BACKGROUND ART

In recent trends, ultra-small LEDs ranging from tens to hundreds of micrometers in size are increasingly being utilized as light sources for various displays due to their advantages such as miniaturization, lightweight, and low power consumption.

These ultra-small LEDs can be divided into mini LEDs with chip sizes ranging from 100 µm to 300 µm and micro LEDs with chip sizes ranging from 5 µm to 100 µm.

Mini LEDs are relatively larger in chip size compared to micro LEDs, so they are mainly used in backlight units for LCD displays rather than light emitting pixels for LED displays.

Micro LEDs, due to their smaller chip size and individual pixel or light source capability, are expected to be widely used in various applications requiring miniaturization, low power consumption, and lightweight. Research on utilizing arrays of micro LEDs as pixels for LED displays for directly emitting images is actively underway.

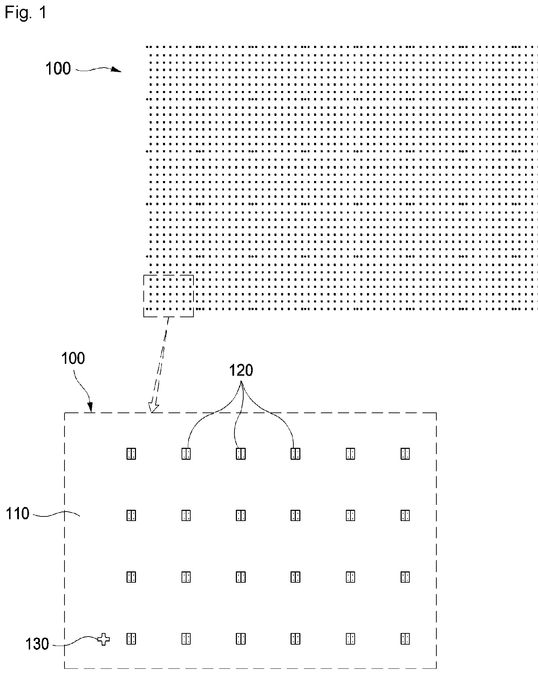

Figure 1 shows a schematic diagram of a typical arrangement of an array of ultra-small LEDs (e.g., mini LEDs).

Referring to Figure 1, when applying these mini LEDs to a backlight unit, a mini LED array is formed by arranging one or more serially connected mini LED chip groups horizontally and vertically.

Traditionally, mini LEDs are provided in the form of a mini LED array (100) where mini LED chip groups (120) are arranged horizontally and vertically. Each mini LED chip group (120) consists of multiple mini LED chips with chip sizes ranging from 100 µm to 200 µm serially connected on a substrate (110).

Traditionally, mini LED chips are typically processed by forming circuits for each chip on a wafer and then separating them into individual chips.

These separated mini LED chips undergo multiple transfer or mounting processes onto the substrate during packaging and modularization processes.

The conventional transfer process of LED chips typically involves transferring to a tape or substrate, or directly mounting on a circuit board (e.g., rigid PCB or flexible PCB). A typical type of transfer device for LED chips is a pick and place type transfer device.

As an example of such a pick and place type transfer device, Korean Registered Patent Publication No. 1879029 (registered on July 10, 2018) discloses a chip transfer device and method in which each LED chip is picked up one by one and placed on a substrate to transfer each LED chip to the substrate.

Furthermore, Korean Registered Patent Publication No. 2130124 (registered on June 29, 2020) discloses a mounting device using an ejector pin for individual transfer. The mounting device used for attaching parts attached to a sheet to a substrate, includes a head driving unit and a mounting head attached to the head driving unit, wherein the mounting head includes a head body, a plunger vertically reciprocating in the head body, an ejector pin fixed to the head body and penetrating the plunger in the reciprocating direction, and a solenoid for moving the plunger, wherein the plunger is a movable core, and a flange installed at the end of an axis portion and having a shape that narrows towards the end from the axis portion installed at the end of the axis portion, and the flange and the axis portion are installed inside the head body, and the flange and the nozzle are protruded from the head body, and when the solenoid is off, the plunger is most protruded from the head body, and when the solenoid is on, the plunger is moved toward the head driving unit.

Furthermore, Korean Registered Patent Publication No. 1937071 (registered on January 3, 2019) discloses a device for transporting semiconductor devices, comprising: a first frame for holding a wafer tape having first and second sides; a second frame including a first clamping member and a second clamping member, the second frame clamping the output substrate between the first clamping member and the second clamping member, the second frame configured to hold the output substrate such that circuit traces face toward semiconductor device dies on the wafer tape; needles disposed adjacent to the second side of the wafer tape, the needles extending in a direction toward the wafer tape; a needle actuator connected to the needles, the needle actuator moving the needles to a die transfer position where the needles press one of the semiconductor device dies against circuit traces on the output substrate, and a laser for applying energy to the circuit traces on the output substrate facing a position corresponding to the die transfer position where the semiconductor device die contacts the circuit traces on the output substrate, wherein during the transfer operation, energy from the laser is directly applied to the output substrate by the laser to fix the semiconductor device die to a portion of the output substrate corresponding to the die transfer position facing the needle. It is another example of a device using an ejector pin (needle) for individual transfer.

Furthermore, in the Republic of Korea Patent Publication No. 2020-0109493 (published on September 23, 2020), a transfer device for semiconductor chips is disclosed. This transfer device includes a stage where a substrate (the first substrate) with the semiconductor chips mounted on one side is secured; a work table where a second substrate for transferring the semiconductor chips is secured; and a push pin module for transferring the semiconductor chips to the second substrate by pushing a portion corresponding to the semiconductor chips from the other side of the first substrate when the one side of the first substrate and the second substrate are arranged facing each other. The push pin module includes a push pin unit comprising push pins for pushing the other side of the first substrate and a load adjustment unit for adjusting the load applied to the push pins when the semiconductor chips are transferred to the second substrate. The load adjustment unit comprises a VCM (voice coil motor) stator and a VCM mover. Additionally, an implementation device of individual transfer method using an ejector pin (needle) is disclosed as another example, where the VCM mover moves in the opposite direction to the advancing direction of the push pins when a load greater than the preset load is applied to the push pins during the transfer of the semiconductor chips to the second substrate. It also is an example of a device using an ejector pin (needle) for individual transfer.

However, conventional techniques such as pick and place or individual transfer using an ejector pin may be applicable for processes involving mini LED chips with sizes of several hundred micrometers, but for ultra-small LED chip arrays where chip sizes and spacings between chips range from 5 µm to 100 µm, there have been difficulties in applying pick and place methods or individual ultra-small LEDs due to miniaturization of chip sizes and narrowed spacings between chips.

Furthermore, considering the trend of increasing screen sizes of micro LED displays, the need to swiftly and accurately transfer numerous micro LED chips onto large area displays poses practical limitations for traditional pick & place or individual transfer methods.

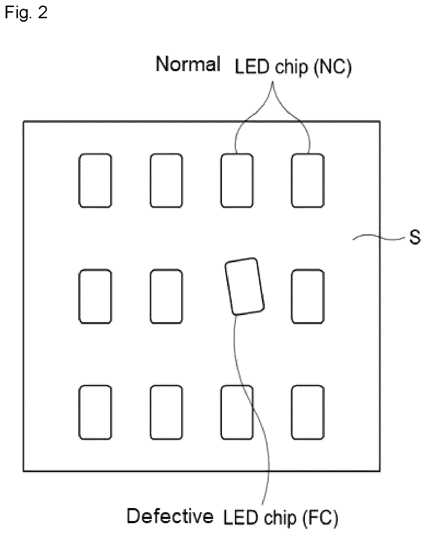

Furthermore, even when using traditional techniques such as pick & place or individual transfer methods with ejector pins to individually transfer or place micro LED chips onto the substrate, there was a risk of misalignment defects occurring on some micro LED chips due to minor vibrations or impacts occurring between transfer processes, as illustrated in Figure 2.

However, traditionally, there have been no ways to address this on-site, leading to scenarios where the boards had to be withdrawn before shipping or subjected to separate rework processes for defect correction. This led to numerous challenges such as an increase in tact time, as well as a decrease in process efficiency and yield.

### DISCLOSURE OF INVENTION

### PROBLEM TO BE SOLVED BY THE INVENTION

The present invention is devised to solve the problems. Even in cases where misalignment defects occur due to slight vibrations or shocks between chip bonding processes, the invention allows for the rapid and accurate removal of defective mini or micro LED chips from the substrate using a transfer technique. Furthermore, by using the transfer technique again to rapidly and accurately attach rework mini or micro LED chips to the positions from which the defective mini or micro LED chips have been removed, the invention aims to provide a transfer-based rework apparatus for ultra-small LED chips such as mini or micro LED chips, which significantly reduces cycle time and greatly improves process efficiency and precision.

### MEANS FOR SOLVING THE PROBLEM

In some embodiments of the present invention, the ultra-small LED chip rework apparatus for removing misaligned or defective ultra-small LED chips among multiple ultra-small LED chips attached on a first adhesive layer on a substrate comprises: a stick-shaped detach press head equipped with a second adhesive layer at the lower end of the stick-shaped configuration, the second adhesive layer having stronger adhesive strength than the first adhesive layer, and capable of transferring the misaligned or defective ultra-small LED chip attached to the first adhesive layer to the second adhesive layer by applying pressure to the upper surface of the misaligned or defective ultra-small LED chip; and a driving unit configured to move the detach press head above the substrate in the X, Y, and Z-axis directions.

The ultra-small LED chip rework apparatus further comprises: a stick-shaped attach press head equipped with a third adhesive layer at the lower end of the stick-shaped configuration, the third adhesive layer having weaker adhesive strength than the first adhesive layer, and capable of transferring a replacement normal ultra-small LED chip attached to the third adhesive layer to the first adhesive layer by applying pressure to the upper surface of the first adhesive layer, wherein the driving unit moves the attach press head above the substrate in the X, Y, and Z-axis directions.

In some embodiments of the present invention, the driving unit includes: a linear motion unit configured to move the detach press head in the X and Y-axis directions above the substrate; and an up-down drive unit configured to move the detach press head up and down in the Z-axis direction.

Moreover, the second adhesive layer is formed on one surface of a first transfer film transferred horizontally by a reel-to-reel approach, and the detach press head selectively presses the other surface of the first transfer film to apply pressure.

Similarly, the third adhesive layer is formed on one surface of a second transfer film transferred horizontally by a reel-to-reel approach, and the attach press head selectively presses the other surface of the second transfer film to apply pressure.

In some embodiments of the present invention, the ultra-small LED chip rework method comprises: (a) moving a stick-shaped detach press head equipped with a second adhesive layer at the lower end of the stick-shaped configuration, the second adhesive layer having stronger adhesive strength than a first adhesive layer, to an initial position above a misaligned or defective ultra-small LED chip on a substrate; (b) lowering the detach press head to press the second adhesive layer against the misaligned or defective ultra-small LED chip attached on the first adhesive layer on the substrate; and (c) raising the detach press head back to the initial position so that the misaligned or defective ultra-small LED chip is removed from the first adhesive layer and transferred to the second adhesive layer.

The ultra-small LED chip rework method further comprises: (d) moving a stick-shaped attach press head equipped with a third adhesive layer at the lower end of the stick-shaped configuration, the third adhesive layer having weaker adhesive strength than the first adhesive layer, to an initial position above the first adhesive layer where the misaligned or defective ultra-small LED is removed; (e) lowering the attach press head to press the upper surface of the first adhesive layer so that a replacement normal ultra-small LED chip attached to the third adhesive layer is transferred to the first adhesive layer; and (f) raising the attach press head back to the initial position.

### EFFECT OF THE INVENTION

As described above, the present invention utilizes the difference in adhesion between the underside of the transfer film and the upper surface of the substrate's adhesive layer to swiftly and accurately transfer ultra-small LED chips to the substrate. This results in a significant reduction in cycle time and a substantial improvement in process efficiency for the ultra-small LED transfer process.

Additionally, even if misalignment defects occur due to slight vibrations or shocks between transfer processes, the immediate repair of the misaligned ultra-small LED chips on-site leads to a dramatic improvement in yield and productivity compared to traditional methods using pick & place or ejector pins for transfer.

### BRIEF DESCRIPTION OF DRAWINGS

Fig. 1 illustrates the configuration of a typical ultra-small LED chip array for a backlight unit.
Fig. 2 provides an enlarged view of the ultra-small LED chip array transferred onto a substrate.

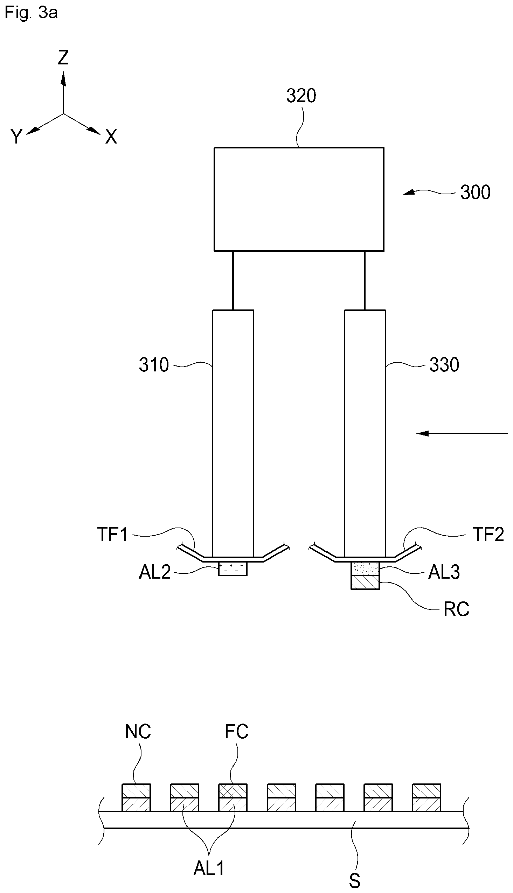

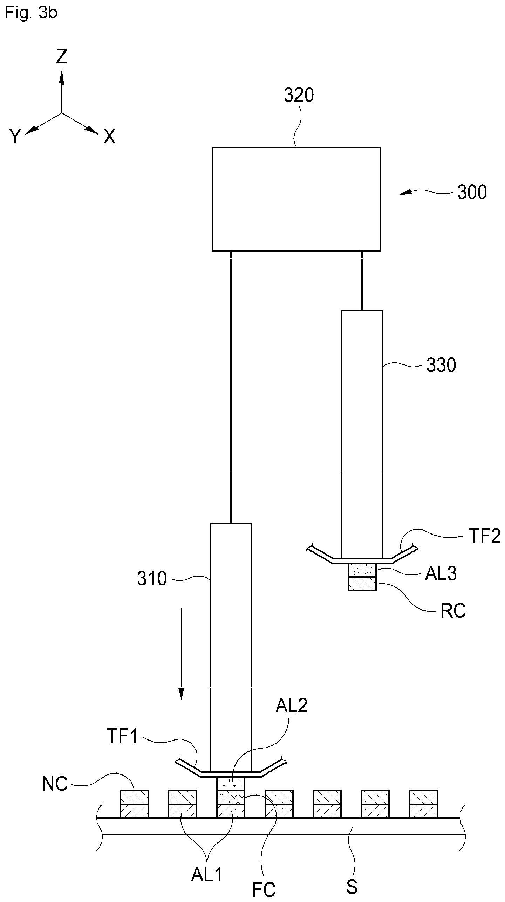

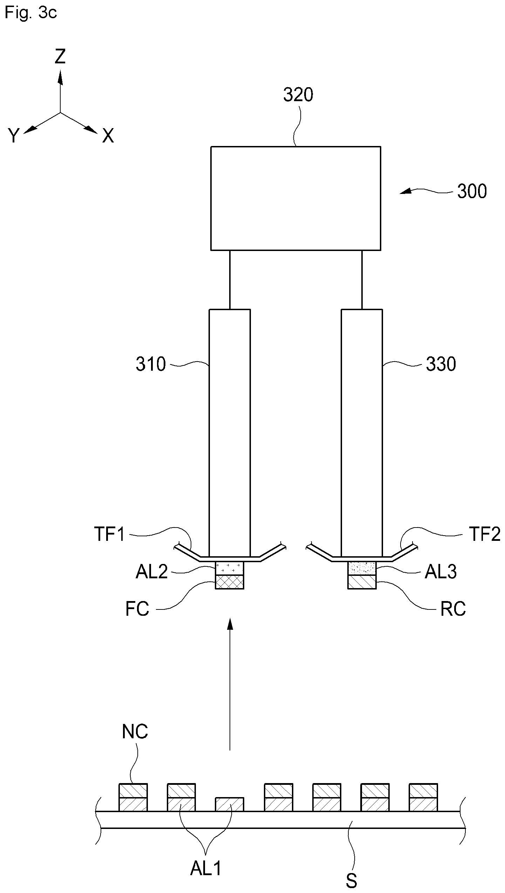

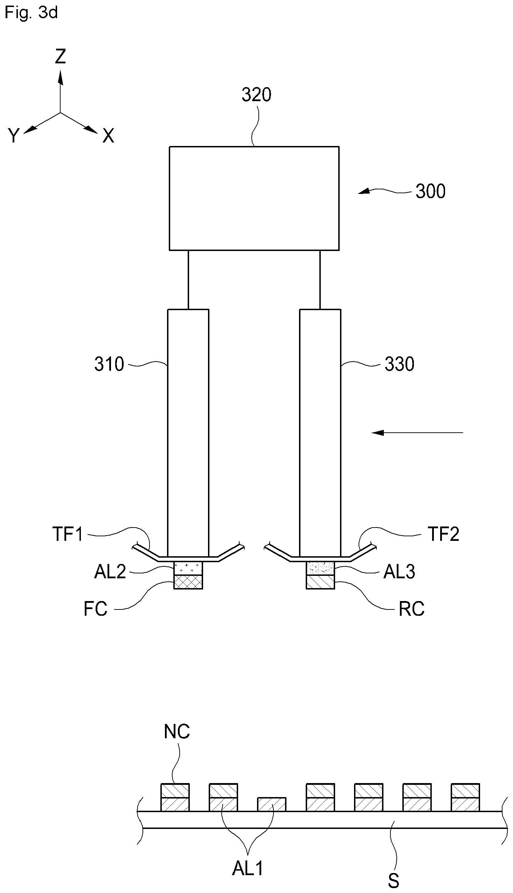

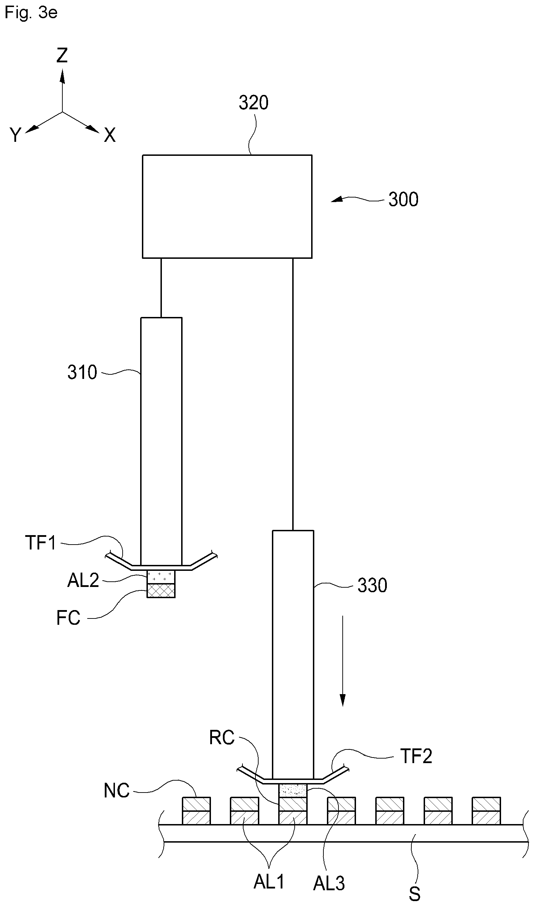

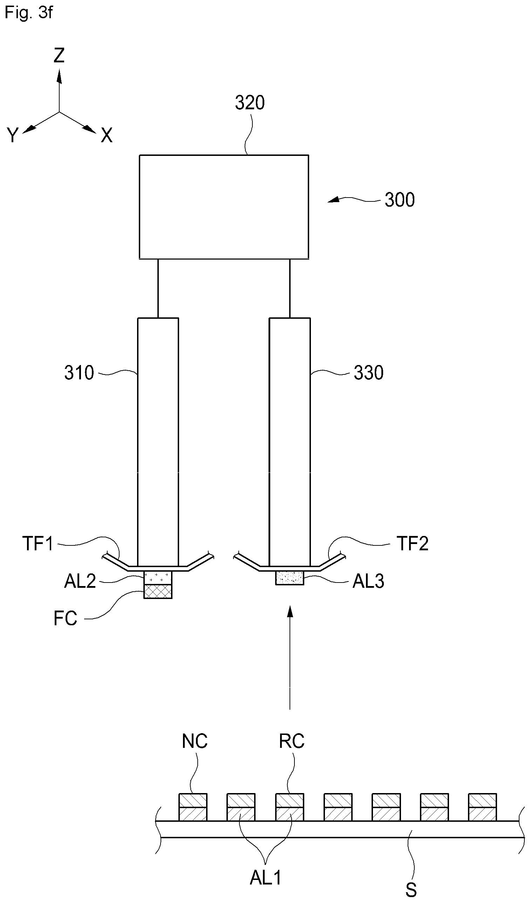

Figs. 3a to 3f show various operational states of the rework apparatus using the transfer technique, wherein Fig. 3a depicts the detach press head in its initial position above the defective ultra-small LED chip targeted for rework, Fig. 3b shows the detach press head being lowered to apply pressure on the defective ultra-small LED chip, Fig. 3c illustrates the detach press head rising after removing the defective ultra-small LED chip through transfer, Fig. 3d displays the attach press head in its initial position above the location where the defective ultra-small LED chip was removed, Fig. 3e demonstrates the attach press head being lowered to attach a normal ultra-small LED chip for rework to the substrate through transfer, and finally Fig. 3f showcases the attach press head rising again after attaching the normal ultra-small LED chip to the substrate.

### MODE(S) FOR CARRYING OUT THE INVENTION

The terminology used in this specification is merely used to describe specific embodiments and is not intended to limit the invention. Unless otherwise specified, singular expressions encompass plural expressions unless the context clearly indicates otherwise. Terms such as "comprising," "having," or "including" in this specification are intended to specify the existence of the features, numbers, steps, operations, components, parts, or combinations thereof as described in this specification, and do not preclude the existence or possibility of one or more other features, numbers, steps, operations, components, parts, or combinations thereof.

Unless otherwise defined in this specification, all terms used herein, including technical or scientific terms, have the same meaning as those understood by those skilled in the art to which the invention pertains.

Terms commonly defined in dictionaries should be interpreted to have the meanings consistent with the relevant context of the technology and should not be interpreted in an ideal or overly formal sense unless expressly defined in this specification.

Hereinafter, specific aspects of an ultra-small LED chip rework apparatus using a transfer technique according to some embodiments of the present invention will be explained in detail, with reference to the attached drawings.

Figs. 3a to 3f show the operation of an ultra-small LED chip rework apparatus using the transfer technique of the present invention. Fig. 3a shows the detach press head in the initial position above the defective ultra-small LED chip to be reworked. Fig. 3b shows the detach press head pressing down to apply pressure to the defective ultra-small LED chip. Fig. 3c shows the detach press head rising back to its initial position while removing the defective ultra-small LED chip by the transfer technique. Fig. 3d shows the attach press head moving to its initial position above the substrate after removing the defective ultra-small LED chip. Fig. 3e shows the attach press head pressing down to attach a normal ultra-small LED chip to the substrate using the transfer technique. Finally, Fig. 3f shows the attach press head rising again after attaching the normal ultra-small LED chip to the substrate.

An ultra-small LED chip rework apparatus (300) using the transfer technique of the present invention is an apparatus for removing and replacing defective ultra-small LED chips (FC) misaligned or defective in performance among multiple ultra-small LED chips (NC). The multiple ultra-small LED chips (NC) may have previously been transferred onto a substrate (S) using a first adhesive layer (AL1).

The multiple ultra-small LED chips (NC) transferred onto the substrate (S) may form, for example, a flexible micro LED array on a flexible substrate (S), with multiple micro LED chips (NC) of 20µm × 40µm size repeatedly placed at a constant interval (e.g., 20µm) using the transfer technique. (Refer to Fig. 2)

To selectively rework (i.e., replace a defective LED chip (FC) with a normal LED chip (RC)) defective ultra-small LED chips (FC) among the multiple ultra-small LED chips (NC), the rework apparatus (300) of the present invention comprises a stick-shaped detach press head (310) with a second adhesive layer (AL2) at the lower end of the stick, the second adhesive layer (AL2) having a stronger adhesion than the first adhesive layer (AL1). The detach press head (310) applies pressure to the upper surface of the defective ultra-small LED chip (FC) so that the defective ultra-small LED chip (FC) attached to the first adhesive layer (AL1) may be transferred to the second adhesive layer (AL2) and removed from the substrate (S).

Referring to Figs. 3a to 3f, the second adhesive layer (AL2) may be formed on one surface of a first transfer film (TF1) transferred horizontally by a reel-to-reel device, that is, the second adhesive layer (AL2) may be in the form of a transfer adhesive tape (i.e., adhesive tape for transfer approach) applied to one surface of the first transfer film (TF1).

The detach press head (310) applies pressure in the vertical direction on the other surface of the first transfer film (TF1), selectively removing the defective ultra-small LED chip (FC) from the first adhesive layer (AL1) and transferring it to the second adhesive layer (AL2). Then, the first transfer film (TF1) is horizontally transferred a certain distance for the next detach operation.

Furthermore, a driving unit (320) is provided to selectively move the detach press head (310) and/or the attach press head (330) in the X, Y, and Z directions above the substrate (S).

According to one embodiment, the driving unit (320) may include a linear motion unit (not shown) that moves the detach press head (310) in the X and Y directions on the plane and an up-down drive unit (not shown) that moves the detach press head (310) up and down in the Z direction.

Furthermore, beside the detach press head (310), an attach press head (330) is provided.

The attach press head (330) moves in the X, Y, and Z directions above the substrate (S) by the driving unit (320) and is typically stick-shaped with cross sections in the micrometer range. The lower end of the attach press head (310) is equipped with a third adhesive layer (AL3) having a weaker adhesion than the first adhesive layer (AL1) on the substrate (S).

The lower surface of the third adhesive layer (AL3) is prepared with a replacement normal ultra-small LED chip (RC) attached thereto. As the attach press head (310) presses the replacement normal ultra-small chip (RC) onto the first adhesive layer (AL1), the replacement normal ultra-small LED chip (RC) is transferred from the third adhesive layer (AL3) to the first adhesive layer (AL1).

Referring to Figs. 3a to 3f, the third adhesive layer (AL3) may be formed on one surface of a second transfer film (TF2) transferred horizontally by a reel-to-reel device, that is, the third adhesive layer (AL3) may be in the form of a transfer adhesive tape (i.e., adhesive tape for transfer approach) applied to one surface of the second transfer film (TF2).

The attach press head (330) applies pressure in the vertical direction on the other surface of the second transfer film (TF2), selectively removing the replacement normal ultra-small LED chip (RC) from the third adhesive layer (AL3) and transferring it to the first adhesive layer (AL1). Then, the second transfer film (TF2) is horizontally transferred a certain distance for the next attach operation.

According to some embodiments, the substrate (S) may be a flexible plastic substrate.

Furthermore, according to some embodiments, the first adhesive layer (AL1) on the substrate (S), the second adhesive layer (AL2) provided in the detach press head (310), and the third adhesive layer (AL3) provided in the attach press head (330) may comprise adhesive materials that can be repeatedly attached and detached, i.e., adhesives capable of repeated detachment and attachment.

Furthermore, according to some embodiments, the adhesives are made by combining acrylate or silicone as raw materials with auxiliary additive such as ester rubber or phenolic resin, and low-molecular-weight substances like polyisobutylene.

On the other hand, according to some embodiments, the first adhesive layer (AL1) may be a hot-melt adhesive that selectively provides adhesive strength or bonding force by applying heat or energy.

Additionally, in some embodiments, the first adhesive layer (AL1), the second adhesive layer (AL2), and the third adhesive layer (AL3) can be formed by dispensing the adhesives in liquid state onto the upper surface of the substrate (S) or at the bottom of the detach press head (310) or attach press head (330) respectively, by a dispenser device.

Furthermore, according to some embodiments, the first adhesive layer (AL1) may be an electrically conductive adhesive.

More specifically, the first adhesive layer (AL1) may be an electrically conductive adhesive comprising one or more of metal fillers such as silver, gold, copper, nickel, palladium, platinum, iron, tungsten, molybdenum, zinc, or aluminum, excluding lead (Pb), or conductive carbon materials such as carbon nanotubes, graphene, graphite, or carbon black.

In the case of the metallic filler, due to its higher melting point compared to lead, there may concern about heat damage to functional components during mounting processes. Therefore, a conductive adhesive capable of low-temperature bonding around 150°C, which does not contain lead, may be used.

Specifically, to achieve a conductive adhesive with reduced content of expensive conductive filler while enhancing mechanical properties, materials with excellent thermal or physical characteristics can be used alongside the costly conductive filler at lower concentrations. This enables the conductive adhesive to maintain comparable conductivity to that of the expensive metallic filler while simultaneously possessing superior thermal or physical properties. For instance, conductive nano material with one-dimensional structure such as metal nanowires or carbon nanotubes can be utilized as conductive adhesives.

Hereinafter, by referring to Figs. 3a to 3f, the rework method of ultra-small LED chips using transfer approach of the present invention will be explained step by step.

Step (a) (Fig. 3a): The detach press head (310), equipped with a second adhesive layer (AL2) at the lower end of stick-shaped protrusions, is initially positioned above the defective ultra-small LED chip (FC) on the first adhesive layer (AL1) of the substrate (S).

At this point, an inspection for sorting out the defective ultra-small LED chip (FC) may be performed by a separate vision unit (not shown).

Step (b) (Fig. 3b): The detach press head (310) descends onto the defective ultra-small LED chip (FC), causing the second adhesive layer (AL2) at the lower end of the detach press head (310) to come into contact with the upper surface of the defective ultra-small LED chip (FC) and apply pressure thereon.

Step (c) (Fig. 3c): As the detach press head (310) rises again, the defective ultra-small LED chip (FC) is separated from the first adhesive layer (AL1) and transferred to the second adhesive layer (AL2) having stronger adhesive strength than the first adhesive layer (AL1). The defective ultra-small LED chip (FC) attached to the second adhesive layer (AL2) rises upward with the detach press head (310).

At this time, as the defective ultra-small LED chip (FC) rises while being attached to the second adhesive layer (AL2), it is separated and removed from the first adhesive layer (AL1), leaving only the first adhesive layer (AL1) on the upper surface of the substrate (S).

Step (d) (Fig. 3d): Subsequently, the attach press head (330) is moved to be initially positioned above the upper surface of the first adhesive layer (AL1) where the defective ultra-small LED chip (FC) was removed.

The attach press head (330) is shaped like a stick, like the detach press head (310), and has at its lower end a third adhesive layer (AL3) having an adhesive strength weaker than the first adhesive layer (AL1). A replacement normal ultra-small LED chip (RC) is prepared to be attached to the lower surface of the third adhesive layer (AL3).

That is, to replace the defective ultra-small LED chip (FC) with the replacement normal ultra-small LED chip (RC), the attach press head (330) is being positioned at a position above the first adhesive layer (AL1) where the defective ultra-small LED chip (FC) was removed.

Step (e) (Fig. 3e): Then, the attach press head (330) descends to press the first adhesive layer (AL1), causing the replacement normal ultra-small LED chip (RC) attached to the lower surface of the third adhesive layer (AL3) of the attach press head (330) to transfer to the first adhesive layer (AL1).

Step (f) (Fig. 3f): Finally, the attach press head (330) rises upward to its initial position, leaving the replacement normal ultra-small LED chip (RC) attached to the first adhesive layer (AL1).

In summary, the detach press head (310) is initially positioned above a specific misaligned defective ultra-small LED chip (FC) and then lowered to apply pressure to the upper surface of the defective ultra-small LED chip (FC). The second adhesive layer (AL2) of the detach press head (310) comes into contact with and applies pressure on the upper surface of the defective ultra-small LED chip (FC).

Since the adhesive strength of the second adhesive layer (AL2) is greater than that of the first adhesive layer (AL1), the misaligned defective ultra-small LED chip (FC) is transferred (attached) to the second adhesive layer (AL2) of the detach press head (310) and removed (separated) from the substrate (S) as the detach press head (310) rises.

Subsequently, after the misaligned defective ultra-small LED chip (FC) has been removed, the attach press head (330) is being positioned above the removed position of the misaligned defective ultra-small LED chip (FC) on the upper surface of the first adhesive layer. Then, the attach press head (330) descends to transfer a replacement normal ultra-small LED chip (RC), which has been prepared to be attached to the lower surface of the third adhesive layer (AL3) of the attach press head (330), to the removed position of the misaligned defective ultra-small LED chip (FC) on the upper surface of the first adhesive layer (AL1).

Additionally, the present invention is not limited to the embodiments described above, and those skilled in the art will appreciate that various configurations, additions, deletions, or modifications can be made within the scope of the technical concept of the present invention, even when changing the detailed configuration, number, or arrangement structure of the device, to achieve the same effect.

## Claims

1. An ultra-small LED chip rework apparatus for removing misaligned or defective ultra-small LED chips among multiple ultra-small LED chips attached on a first adhesive layer on a substrate, comprising:
a stick-shaped detach press head equipped with a second adhesive layer at the lower end of the stick-shaped configuration, the second adhesive layer having stronger adhesive strength than the first adhesive layer, and capable of transferring the misaligned or defective ultra-small LED chip attached to the first adhesive layer to the second adhesive layer by applying pressure to the upper surface of the misaligned or defective ultra-small LED chip; and
a driving unit configured to move the detach press head above the substrate in the X, Y, and Z-axis directions.

2. The ultra-small LED chip rework apparatus in Claim 1, further comprising:
a stick-shaped attach press head equipped with a third adhesive layer at the lower end of the stick-shaped configuration, the third adhesive layer having weaker adhesive strength than the first adhesive layer, and capable of transferring a replacement normal ultra-small LED chip attached to the third adhesive layer to the first adhesive layer by applying pressure to the upper surface of the first adhesive layer,
wherein the driving unit moves the attach press head above the substrate in the X, Y, and Z-axis directions.

3. The ultra-small LED chip rework apparatus in Claim 1,
the driving unit includes,
a linear motion unit configured to move the detach press head in the X and Y-axis directions above the substrate; and
an up-down drive unit configured to move the detach press head up and down in the Z-axis direction,

4. The ultra-small LED chip rework apparatus in Claim 1,
the second adhesive layer is formed on one surface of a first transfer film transferred horizontally by a reel-to-reel approach, and the detach press head selectively presses the other surface of the first transfer film to apply pressure.

5. The ultra-small LED chip rework apparatus in Claim 2,
the third adhesive layer is formed on one surface of a second transfer film transferred horizontally by a reel-to-reel approach, and the attach press head selectively presses the other surface of the second transfer film to apply pressure.

6. An ultra-small LED chip rework method, comprising:
(a) moving a stick-shaped detach press head equipped with a second adhesive layer at the lower end of the stick-shaped configuration, the second adhesive layer having stronger adhesive strength than a first adhesive layer, to an initial position above a misaligned or defective ultra-small LED chip on a substrate;
(b) lowering the detach press head to press the second adhesive layer against the misaligned or defective ultra-small LED chip attached on the first adhesive layer on the substrate; and
(c) raising the detach press head back to the initial position so that the misaligned or defective ultra-small LED chip is removed from the first adhesive layer and transferred to the second adhesive layer.

7. The ultra-small LED chip rework method in Claim 6, further comprising:
after step (c),
(d) moving a stick-shaped attach press head equipped with a third adhesive layer at the lower end of the stick-shaped configuration, the third adhesive layer having weaker adhesive strength than the first adhesive layer, to an initial position above the first adhesive layer where the misaligned or defective ultra-small LED is removed;
(e) lowering the attach press head to press the upper surface of the first adhesive layer so that a replacement normal ultra-small LED chip attached to the third adhesive layer is transferred to the first adhesive layer; and
(f) raising the attach press head back to the initial position.
